(19) Europäisches Patentamt
European Patent Office
Office européen des brevets

(11) Veröffentlichungsnummer: **0 502 358 A1**

(12) # EUROPÄISCHE PATENTANMELDUNG

(21) Anmeldenummer: **92102733.0**

(22) Anmeldetag: **19.01.92**

(51) Int. Cl.5: **C08L 81/02**, //(C08L81/02, 61:28,9:06),(C08L81/02,61:28, 51:04),(C08L81/02,61:28,23:16), (C08L81/02,61:28,21:00)

(30) Priorität: **02.03.91 DE 4106694**

(43) Veröffentlichungstag der Anmeldung:
**09.09.92 Patentblatt 92/37**

(84) Benannte Vertragsstaaten:
**BE DE FR GB IT**

(71) Anmelder: **BAYER AG**

**W-5090 Leverkusen 1 Bayerwerk(DE)**

(72) Erfinder: **Rüsseler, Wolfgang, Dr.**
**Buschstrasse 165**
**W-4150 Krefeld(DE)**
Erfinder: **Köhler, Burkhard, Dr.**
**Mündelheimer Strasse 94**
**W-4150 Krefeld 11(DE)**

(54) **PAS, Melaminharze und Kautschuke.**

(57) Die Erfindung betrifft Mischungen aus Polyarylensulfiden (PAS), Melaminharzen und Kautschuken. Die Mischungen zeichnen sich durch sehr gute Zähigkeit aus.

EP 0 502 358 A1

Die Erfindung betrifft Mischungen aus Polyarylensulfiden (PAS), Melaminharzen und Kautschuken. Die Mischungen zeichnen sich durch sehr gute Zähigkeit aus.

Polyarylensulfide sind bekannt (z.B. US-A 3 354 129, EP-A 171021). Sie sind inerte, hochtemperaturbeständige Thermoplaste. Der Einsatz dieser Polymeren, insbesondere des Polyphenylensulfids (PPS) nimmt in Bereichen zu, die bisher Duroplasten vorbehalten waren.

PAS hat unbefriedigende mechanische Eigenschaften für einige Anwendungen im Spritzgußbereich. Insbesondere ist die Schlagzähigkeit für die Praxis nicht ausreichend. Es hat sich daher als Vorteil erwiesen, PAS z.B. durch Abmischung mit anderen Thermoplasten in den genannten Eigenschaften zu verbessern.

Die Verbesserung der mechanischen Eigenschaften von PAS gelingt auch mit Mischungen aus Maleinsäureanhydrid-gepfropften, hydrierten Dienkautschuken und Epoxiden (z.B. JP-A 63 118369).

Ferner lassen sich die mechanischen Eigenschaften von PAS mit Polyisocyanaten verbessern (z.B. JP-A 01118-571). Jedoch ist der Einsatz von Isocyanaten aus Gründen der Arbeitssicherheit problematisch.

Es ist bekannt (JP-A 061155, 83 0330), daß Melaminharze und PPS bei Einbrenntemperaturen unterhalb der Schmelztemperatur des PPS Beschichtungen bilden, die unlöslich und unschmelzbar, also duroplastisch sind. Solche Mischungen sollten daher nicht schmelzeverarbeitbar sein.

Durch Vernetzung wird die Zähigkeit von Thermoplasten üblicherweise vermindert.

Es wurde nun gefunden, daß Abmischungen von Polyarylensulfiden (PAS) mit Melaminharzen und Kautschuken sich durch gute mechanische Eigenschaften, insbesondere eine sehr gute Zähigkeit, auszeichnen.

Gegenstand der Erfindung sind daher Mischungen aus

A) 94,9 bis 40 Gew.-% Polyarylensulfiden, vorzugsweise Polyphenylensulfid,

B) 0,1 bis 5 Gew.-% Melaminharzen der Formel (I) oder (II), vorzugsweise der Formel (I)

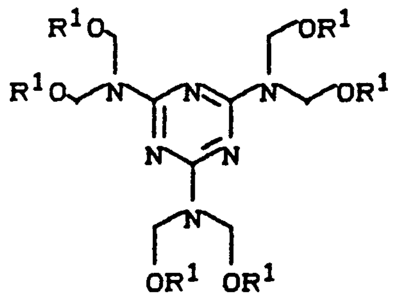

(I) ,

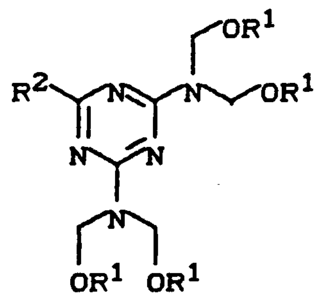

(II) ,

wobei

- $R^1$ für Wasserstoff oder einen aliphatischen $C_{1-22}$-Rest,vorzugsweise für einen Methyl-, Ethyl- oder Butylrest steht und
- $R^2$ für einen aliphatischen $C_{1-22}$- oder einen aromatischen $C_{6-14}$-Rest, vorzugsweise für Phenyl steht und bis zu zwei Alkoxymethylreste der erfindungsgemäßen Stoffe I oder II durch Wasserstoff ersetzt sein können,

C) 5 bis 59,9 Gew.-%, vorzugsweise 10 bis 25 Gew.-% Kautschuken und

D) bezogen auf 100 Teile der Mischung (A + B + C) 0-300 Teile anorganische Füll- oder Verstärkungsstoffe.

Die Abmischung der Komponenten erfolgt in Knetern oder Extrudern bei Temperaturen von 280 °C bis 350 °C in der Schmelze.

Beispiele für Melaminharze der Formel (I) sind
Hexamethoxymethylmelamin, Hexaethoxymethylmelamin, Hexabutoxymethylmelamin, Tetramethoxymethylmelamin, Pentamethoxymethylmelamin oder Hexahydroxymethylmelamin.

Beispiele für Harze der Formel (II) sind
Tetramethoxymethylbenzoguanamin, Tetraethoxymethylbenzoguanamin, Tetramethoxymethylacetoguanamin und Tetrabutoxymethylacetoguanamin.

Die Substanzen der Formel (I) sind z.T. kommerziell erhältlich (z.B. Cymel 303® der Fa. Cyanamid) oder aus Melamin Formaldehyd und aliphatischen Alkohlen zugänglich. Die Substanzen der Formel II sind ebenfalls z.T. kommerziell erhältlich (Cymel 1123® der Fa. Cyanamid) oder aus Benzoguanamin (1,3-Diamino-5-phenyl-triazin) oder Acetoguanamin (1,3-Diamino-5-methyl-triazin), Formaldehyd und aliphatischen Alkoholen zugänglich.

Beispiele für Kautschuke sind statistische Polymere oder Blockcopolymere mit einer Glastemperatur unter -10 ° C aus Ethylen, Propylen, Butadien, Isopren, nicht konjugierten Dienen, Styrol, Acrylnitril, Vinylestern, Acrylsäureestern oder Methacrylsäureestern, die zusätzlich mit Acrylnitril, Styrol, konjugierten Dienen, Acrylsäureestern, Maleinsäureanhydrid oder Methacrylsäureestern gepfropft sein können und deren gegebenenfalls vorhandenen Diensequenzen hydriert sein können oder vorzugsweise Copolymere des Ethylens mit Acrylaten aliphatischer Alkohole und Maleinsäureanhydrid sowie des Ethylens mit Acrylaten aliphatischer Alkohole und Glycidylmethacrylat oder Glycidylacrylat oder Alkylglycidylether. Die bevorzugt eingesetzten Copolymere sind kommerziell erhältlich (Lotader® der Fa. CdF).

Als anorganische Füllstoffe oder Verstärkungsstoffe seien Glasfasern, Glaskugeln, Glimmer, Talkum, Quarzmehl, Kaolin, Metalloxide und Sulfide, z.B. $TiO_2$, ZnO, ZnS, Graphit, Ruß, Fasern, z.B. aus Quarz oder Kohlenstoff, Carbonate wie z.B. $MgCO_3$, $CaCO_3$ oder Sulfate wie z.B. $CaSO_4$, $BaSO_4$ genannt.

Als weitere übliche Zusatzstoffe können Pigmente, Entformungsmittel, E-Wachse, Fließhilfsmittel, Nucleirungsmittel oder Stabilisatoren eingesetzt werden.

Es können 0 bis 300 Gew.-%, bezogen auf PAS, Füllstoffe und Zusatzstoffe eingesetzt werden.

Die erfindungsgemäßen Mischungen können auf übliche Art und Weise durch Extrusion hergestellt werden.

Die erfindungsgemäßen Mischungen können auf übliche Weise zu Formteilen, Halbzeut, Leiterplatten, Fasern, Folien, Profilen usw. verarbeitet werden. Die erfindungsgemäßen Mischungen können generell in vorteilhafter Weise dort eingesetzt werden, wo thermoplastisch verarbeitbare Massen eingesetzt werden.

## Beispiele

Die Herstellung der erfindungsgemäßen Mischungen erfolgte auf einem Doppelwellenextruder ZSK 32 von Werner & Pfleiderer bei 320 ° C.

Das verwendete PPS wies eine Schmelzviskosität von 65 PAS (306 ° C, 1000 l/s) auf und wurde nach EP-A 171 021 hergestellt. Alle %-Angaben sind Gew-.%.

Die Mischungen wurden granuliert und zu Prüfstäben der Maße 80x10x4 mm verspritzt. Diese wurden hinsichtlich Kerbschlagzähigkeit (ISO 180-Methode 1A) untersucht.

### Vergleichsbeispiel 1

Gemischt wurden 80 % PPS und 20 % Cariflex CTR 101® (Styrol-Butadienblockcopolymer der Fa. Shell). Die Kerbschlagzähigkeit betrug 4.9 $kJ/m^2$.

### Beispiel 1

Gemischt wurden 78 % PPS, 20 % Cariflex CTR 101® und 2 % Cymel 303® (Hexamethoxymethylmelamin der Fa. Cyanamid). Die Kerbschlagzähigkeit betrug 5,2 $kJ/m^2$.

### Vergleichsbeispiel 2

Gemischt wurden 80 % PPS und 20 % Exxelor 1803® (Maleinsäureanhydrid gepropftes Ethylen-Propylen-Copolymer der Fa. Exxon). Die Kerbschlagzähigkeit betrug 7,2 $kJ/m^2$.

### Beispiel 2

Gemischt wurden 78 % PPS, 20 % Exxelor 1803® und 2 % Cymel 303®. Die Kerbschlagzähigkeit betrug 11,4 $kJ/m^2$.

### Vergleichsbeispiel 3

Gemischt wurden 80 % PPS und 20 % Buna AP® (Ethylen-Propylen-Dien-Kautschuk der Fa. Hüls). Die Kerbschlagzähigkeit betrug 5,1 $kJ/m^2$.

### Beispiel 3

Gemischt wurden 80 % PPS, 20 % Buna AP® und 2 % Cymel 303®. Die Kerbschlagzähigkeit betrug 8,3 kJ/$m^2$.

Vergleichsbeispiel 4

Gemischt wurden 80 % PPS und 20 % P75 28B4® (Pfropfkautschuk der Fa. Bayer). Die Kerbschlagzähigkeit betrug 5,3 kJ/$m^2$.

Beispiel 4

Gemischt wurden 78 % PPS, 20 % 28B4® und 2 % Cymel 303®. Die Kerbschlagzähigkeit betrug 7,5 kJ/$m^2$.

Vergleichsbeispiel 5

Gemischt wurden 80 % PPS und 20 % Lotader 5500® (Ethylen-Acrylat-Maleinsäuranhydrid-Copolymer). Die Mischung konnte nicht durch Spritzguß verarbeitet werden (brüchig).

Beispiel 5 (Vorzugsbereich)

Gemischt wurden 78 % PPS, 20 % Lotader 5500® und 2 % Cymel 303®. Die Kerbschlagzähigkeit betrug 35,3 kJ/$m^2$.

Vergleichsbeispiel 6

Gemischt wurden 80 % PPS und 20 % Lotader AX 8660® (epoxygruppenhaltiges Ethylen-Acrylat-Copolymer). Die Kerbschlagzähigkeit betrug 10,6 kJ/$m^2$.

Beispiel 6 (Vorzugsbereich)

Gemischt wurden 78 % PPS, 20 % Lotader AX 8660® und 2 % Cymel 303®. Die Kerbschlagzähigkeit betrug 40,7 kJ/$m^2$.

Die Beispiele verdeutlichen die Zähigkeitszunahme von schlagzähmodifiziertem PPS durch Melaminharze.

## Patentansprüche

**1.** Mischungen aus

A) 94,9 bis 40 Gew.-% Polyarylensulfiden,

B) 0,1 bis 5 Gew.-% Melaminharzen der Formel (I) oder (II)

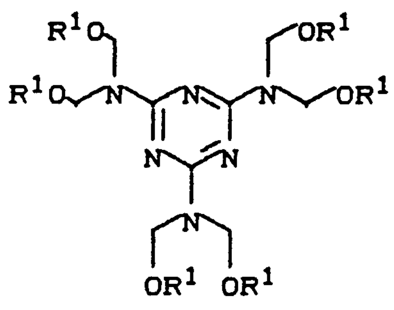

(I) ,

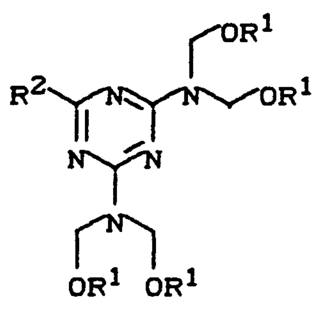

(II) ,

wobei

$R^1$ für Wasserstoff oder einen aliphatischen $C_{1-22}$-Rest und

$R^2$ für einen aliphatischen $C_{1-22}$- oder einen aromatischen $C_{6-14}$-Rest steht und bis zu zwei

Alkoxymethylreste der erfindungsgemäßen Stoffe (I) oder (II) durch Wasserstoff ersetzt sein können,

C) 5 bis 59,9 Gew.-% Kautschuken und

D) bezogen auf 100 Teile der Mischung (A + B + C) 0-300 Teile anorganische Füll- oder Verstärkungsstoffe.

**2.** Verwendung der Mischungen aus Anspruch 1 zur Herstellung geformter Körper.

Europäisches Patentamt

# EUROPÄISCHER RECHERCHENBERICHT

Nummer der Anmeldung

EP 92 10 2733

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | US-A-3 998 767 (R.J.WALTON)<br>* Spalte 4, Zeile 1 - Zeile 12; Ansprüche 1-8; Beispiele 1,2; Tabellen 1,2 *<br>--- | 1,2 | C08L81/02<br>//(C08L81/02, 61:28,9:06), (C08L81/02, 61:28,51:04), (C08L81/02, 61:28,23:16), (C08L81/02, 61:28,21:00) |
| A | EP-A-0 406 553 (ASAHI KASEI KOGYO KABUSHIKI KAISHA)<br>* Ansprüche 1-3 *<br>--- | 1,2 | |
| A | EP-A-0 345 094 (TORAY INDUSTRIES)<br>* Ansprüche 1,9 *<br>--- | 1,2 | |
| A | EP-A-0 380 108 (MITSUBISHI RAYON CO)<br>* Ansprüche 1,7-12 *<br>--- | 1,2 | |
| D,A | PATENT ABSTRACTS OF JAPAN<br>vol. 10, no. 67 (C-333)(2124) 15. März 1986 ( DAINIPPON INK ) 18. Oktober 1985<br>& JP-A-60 206 873<br>* Zusammenfassung *<br>----- | 1 | |
| | | | **RECHERCHIERTE SACHGEBIETE (Int. Cl.5)** |
| | | | C08L |

Der vorliegende Recherchenbericht wurde für alle Patentansprüche erstellt

| Recherchenort | Abschlußdatum der Recherche | Prüfer |
|---|---|---|
| DEN HAAG | 26 MAI 1992 | KLIER E.K. |

**KATEGORIE DER GENANNTEN DOKUMENTE**

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPO FORM 1503 03.82 (P0403)